# EUROPÄISCHE PATENTSCHRIFT

(11) **EP 0 525 385 B1**
(45) Veröffentlichungstag und Bekanntmachung des Hinweises auf die Patenterteilung: **19.03.1997**
(21) Anmeldenummer: 92110645.6
(22) Anmeldetag: 24.06.1992
(51) Int. Cl.: C04B 35/00, C04B 35/653, H01L 39/12, H01L 39/24, H01L 39/14

(54) **Stabilisierter, keramischer Hochtemperatur-Supraleiter sowie Verfahren zu seiner Herstellung**
Stabilized ceramic high temperature superconductor and process for its production
Supraconducteur céramique à haute, température, stabilisé et son procédé de préparation

(30) Priorität: 27.07.1991 DE 4124980
(43) Veröffentlichungstag der Anmeldung: 03.02.1993
(73) Patentinhaber: HOECHST AKTIENGESELLSCHAFT, 65926 Frankfurt am Main (DE)
(72) Erfinder: Bock, Joachim, Dr., W-5042 Erftstadt (DE); Preisler, Eberhard, Dr., W-5042 Erftstadt (DE)

(56) Entgegenhaltungen:
- EP-A- 0 299 788
- EP-A- 0 380 115
- DE-A- 3 839 470
- PATENT ABSTRACTS OF JAPAN vol. 15, no. 308 (E-97)7. August 1991

## Beschreibung

Die vorliegende Erfindung betrifft einen mit metallischen Leitern stabilisierten, keramischen Hochtemperatur-Supraleiter sowie ein Verfahren zu seiner Herstellung.

Aus der DE-OS 38 30 092 ist bekannt, Formkörper aus Hochtemperatur-Supraleiter-Material dadurch herzustellen, daß man aus den Oxiden des Bismuts, Strontiums, Calciums und Kupfers in einem Molverhältnis der Metalle von 2 : 2 : 1 : 2 im Temperaturbereich von 870 °C bis 1100 °C eine homogene Schmelze herstellt, in Kokillen vergießt und darin erstarren läßt. Die aus den Kokillen entnommenen Gußkörper tempert man zunächst bei Temperaturen von 780 °C bis 850 °C und behandelt sie schließlich in sauerstoffhaltiger Atmosphäre von 600 bis 830 °C.

Nachteilig bei allen bisher bekannten Hochtemperatur-Supraleitern ist ihre geringe mechanische Stabilität, die bei einem Bruch des Hochtemperatur-Supraleiters zu einem niederohmigen Kurzschluß im Stromdurchgang führt. Es besteht die Gefahr, daß durch die an dieser Bruchstelle entwickelte Ohm'sche Wärme die Temperatur ansteigt und der Hochtemperatur-Supraleiter normalleitend wird. Bei einem normalleitenden Hochtemperatur-Supraleiter kann die entwickelte Ohm'sche Wärme zu seiner vollständigen Zerstörung führen.

Bei der Herstellung großer Spulen aus Hochtemperatur-Supraleiter kommt es durch den sogenannten Degradationseffekt zu ihrer Zerstörung, wenn die im Feld gespeicherte Energie nicht abgeführt wird. Unter dem Degradationseffekt versteht man, daß bereits bei Belastungsströmen, die um den Faktor 2 und mehr kleiner sind als der erwartete kritische Strom, Instabilitäten auftreten, die zur völligen Normalleitung des Hochtemperatur-Supraleiters führen, vgl. hierzu Werner Buckel, "Supraleitung", Grundlagen und Anwendungen, 3. Aufl. (1984), Seiten 227 ff.

Bei metallischen Supraleitern, die aus Legierungen von Niob/Titan oder Niob/Zinn bestehen, treten diese Zerstörungen in gleicher Weise ein. Die Stabilisierung von Drähten aus diesen Metallegierungen erreicht man durch sogenannte Verbundleiter. Bei den Verbundleitern wird z.B. ein Stab der Metallegierung in einen Kupferklotz geeigneter Dimension eingebracht und das ganze Stück auf Drahtstärke herabgezogen. Auf diese Weise entsteht ein hervorragender Kontakt zwischen dem Supraleiter und der Kupferumhüllung. Die so hergestellten Drähte sind für die Spulenherstellung geeignet. Wenn der Supraleiter normalleitend wird, übernimmt die Kupferumhüllung kurzfristig, d.h. bis zur Stromabschaltung, den Stromtransport. Die Zerstörung der Spule wird auf diese Weise verhindert.

Diese Art der Stabilisierung durch Einbetten in eine Metallmatrix ist auf Massivteile aus Hochtemperatur-Supraleitern auf der Basis von Metalloxid-Gemischen des Bismuts, Strontiums, Calciums und Kupfers nicht übertragbar, da Formkörper aus diesen Metalloxid-Gemischen zu spröde sind und sich nicht mechanisch verformen lassen.

Es ist daher Aufgabe der vorliegenden Erfindung, einen stabilisierten, keramischen Hochtemperatur-Supraleiter bereitzustellen sowie ein Verfahren zu seiner Herstellung anzugeben, bei welchem eine Bruchstelle so sicher stabilisiert wird, daß eine rechtzeitige Stromabschaltung erfolgen kann und Folgeschäden vermieden werden. Die Normalleitung und damit die Zerstörung des Hochtemperatur-Supraleiters durch den Degradationseffekt soll verhindert werden.

Die Aufgabe konnte überraschend dadurch gelöst werden, daß man einen metallischen Leiter parallel zum Hochtemperatur-Supraleiter führt, wobei der Hochtemperatur-Supraleiter mit dem metallischen Leiter in Kontakt steht, und wobei der Hochtemperatur-Supraleiter und der metallische Leiter gemeinsame Kontaktstücke aufweisen, an welcher der Stromanschluß erfolgt.

Der Hochtemperatur-Supraleiter gemäß der Erfindung kann wahlweise auch noch dadurch ausgebildet sein, daß
a) der metallische Leiter aus Edelmetall besteht;
b) man als Edelmetall Ag, Au, Ru, Os, Rh, Ir, Pd oder Pt oder eine diese Edelmetalle enthaltende Legierung verwendet;
c) der metallische Leiter von dem Hochtemperatur-Supraleiter vollständig oder teilweise umhüllt ist;
d) der Hochtemperatur-Supraleiter und der metallische Leiter gemeinsame Kontaktstücke aufweisen, an welchen der Stromanschluß erfolgt;
e) der Hochtemperatur-Supraleiter aus den geschmolzenen Metalloxiden in Form eines Rohres im Schleudergußverfahren hergestellt wird;
f) im Schleudergußverfahren die Rohrenden mit ringförmigen Kontaktstücken für den Stromanschluß ausgerüstet werden, wobei die beiden Kontaktstücke durch einen oder mehrere metallische Leiter verbunden sind.

Ein Verfahren zur Herstellung des erfindungsgemäßen stabilisierten, keramischen Hochtemperatur-Supraleiters kann dadurch gekennzeichnet sein, daß man in einer Matrize einen oder mehrere metallische Leiter parallel zur Matrizen-Längsachse anordnet, die Matrize mit den aufgeschmolzenen Metalloxiden von Bismut, Strontium, Calcium und Kupfer im Molverhältnis der Metalle von 2 : 2 : 1 : 2 auffüllt und erstarren läßt, die erstarrte Schmelze der Matrize entnimmt und in einer ersten Stufe bei Temperaturen von 710 bis 810 °C und einer zweiten Stufe in sauerstoffhaltiger Atmosphäre bei Temperaturen von 750 bis 870 °C tempert.

Ein weiteres Verfahren zur Herstellung des erfindungsgemäßen stabilisierten, keramischen Supraleiters kann dadurch gekennzeichnet sein, daß man in einer Matrize einen oder mehrere metallische Leiter parallel zur Matrizen-Längsachse anordnet und die Matrize mit pulverförmigen Metalloxiden oder fertigem Supraleiterpulver auffüllt und die Metalloxide in der Matrize vollständig oder teilweise aufschmilzt, danach in einer ersten Stufe in Luftatmosphäre bei 710 bis 810 °C und einer zweiten Stufe in sauerstoffhaltiger Atmosphäre bei 750 bis 870 °C tempert. Als Matrizenmaterial setzt man Silber oder Gold ein.

Die Verfahren gemäß der Erfindung können wahlweise auch noch dadurch ausgestaltet sein, daß man
g) in der ersten Stufe 0,5 bis 60 Stunden tempert,
h) in der zweiten Stufe 6 bis 100 Stunden tempert.

Beim erfindungsgemäßen stabilisierten, keramischen Hochtemperatur-Supraleiter wird mit Sicherheit ausgeschlossen, daß eine kurzzeitig auftretende Normalleitung von einigen Sekunden zur Zerstörung des Hochtemperatur-Supraleiters führt. Beispielsweise ist ein metallischer Leiter mit einem Querschnitt von 0,2 mm² für die Stabilisierung einer im Hochtemperatur-Supraleiter fließenden Stromstärke von 20 A völlig ausreichend.

Die Stabilisierung des keramischen Hochtemperatur-Supraleiters mit metallischen Leitern kann auf verschiedenen Wegen erfolgen:

In einem ersten Schritt wird der metallische Leiter vollständig oder teilweise mit Schmelze umhüllt und die gesamte Anordnung getempert, wobei der supraleitende Zustand und ein guter elektrischer Kontakt zwischen dem Supraleitermaterial und dem metallischen Leiter erreicht werden. Das für die eigentliche Stromzufuhr notwendige Kontaktstück kann durch ein unabhängiges Verfahren wie z.B. durch das Aufsputtern von Gold hergestellt werden.

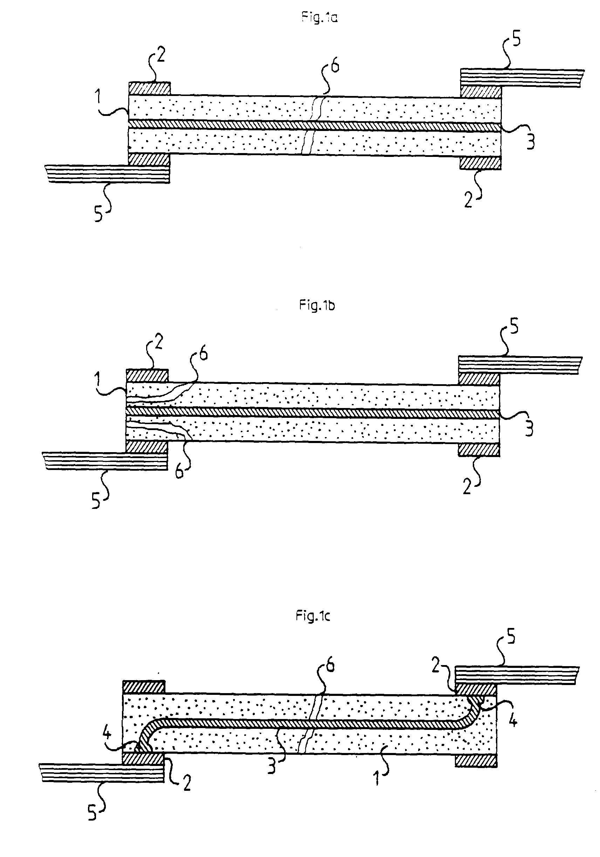

Erhalten wird dann eine Anordnung, wie sie in Fig. 1a wiedergegeben ist. Für den Fall, daß der keramische Hochtemperatur-Supraleiter senkrecht zu seiner Längsachse bricht, wird der Strom über den mittig durch den Stab verlaufenden Draht abgeführt. Im Falle eines in Richtung der Längsachse verlaufenden Schadens (Fig. 1b) wäre der metallische Leiter jedoch wirkungslos, da bei dieser Anordnung keine direkte Verbindung zwischen dem Kontaktstück und dem metallischen Leiter besteht. Eine Anordnung wie in Fig. 1c ist daher in jedem Falle vorzuziehen.

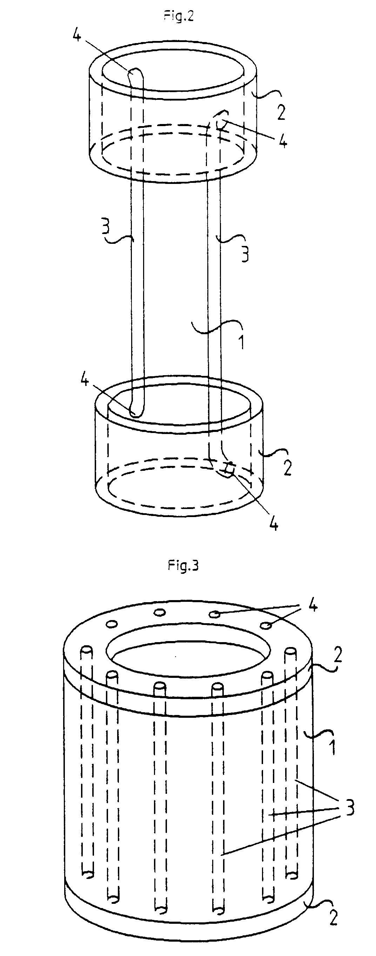

Die Herstellung von Massivbauteilen mit elektrischen Kontakten ist dann oft einfacher, wenn feste, kompakte Metallstücke für die Stromzufuhr direkt mit in die Schmelze eingebettet werden. Es lassen sich sogar die für die Stromzufuhr notwendige Kontaktierung und die für den sicheren Betrieb eines Bauteils notwendige elektrische Stabilisierung mit nur einer Anordnung erreichen wie beispielsweise in Fig. 2 gezeigt ist: Zwei Ringe aus dünnem Edelmetallblech sind über zwei dünne Edelmetalldrähte miteinander verbunden. In einer Matrize wird dann der Raum zwischen den Ringen mit supraleitendem Material gefüllt. Während die beiden Ringe mit großer Kontaktfläche für einen geringen Übergangswiderstand sorgen, gewährleisten die Edelmetalldrähte die elektrische Stabilisierung des gesamten Hochtemperatur-Supraleiters. Im Falle eines plötzlich auftretenden Bruches oder Normalleitung des Hochtemperatur-Supraleiters wird der Strom zumindest solange über den Edelmetalleiter transportiert, bis eine Sicherheitsabschaltung erfolgen kann.

Aus der Sicht der Stabilisierung betrachtet, ist es egal, ob der metallische Leiter parallel außen oder innen zum Hochtemperatur-Supraleiter angeordnet ist. Die Außenanordnung hat jedoch den Nachteil, daß der metallische Leiter mechanisch abgerissen werden kann. Einer innenliegenden Anordnung des metallischen Leiters im Hochtemperatur-Supraleiter ist deshalb der Vorzug zu geben. Neben der kompakteren Bauweise und einer geringeren Abrißgefahr verleiht die innenliegende Anordnung des metallischen Leiters dem Hochtemperatur-Supraleiter auch noch eine erhöhte Bruchfestigkeit.

Die Erfindung wird durch die Beispiele und schematischen Zeichnungen näher erläutert:

In den Fig. 1a, 1b und 1c ist ein Längsschnitt durch einen Hochtemperatur-Supraleiter dargestellt. Der metallische Leiter 3 ist im keramischen Hochtemperatur-Supraleiter-Material 1 angeordnet. Der Hochtemperatur-Supraleiter wird über die Zuleitung 5 und das Kontaktstück 2 an einen Stromkreis angeschlossen. 6 verdeutlicht zwei verschiedene Möglichkeiten eines Bruches in dem keramischen Hochtemperatur-Supraleiter-Material. In Fig. 1c ist der metallische Leiter 3 über eine Schweißstelle 4 mit dem Kontaktstück 2 verbunden.

Fig. 2 zeigt die räumliche Darstellung eines Käfigs, der aus den ringförmigen Kontaktstücken 2, die mit dem metallischen Leiter 3 über die Schweißstelle 4 verbunden sind, gebildet ist. Der Käfig wird mit keramischem Hochtemperatur-Supraleiter-Material 1 gefüllt.

Fig. 3 zeigt die räumliche Darstellung eines nach dem Schleuderguß-Verfahren hergestellten Zylinders aus Hochtemperatur-Supraleiter-Material, der mit zwei Kontaktstücken 2 aus Silberblech versehen ist, die über die Schweißpunkte 4 und den elektrischen Leiter 3 miteinander verbunden sind.

### Beispiel 1a: (Vergleichsbeispiel Arbeitsweise gemäß Fig. 1a)

In eine oben offene, rechteckige Kupferform (Abmessungen: 15 x 15 x 60 mm³) wurden in die Mitten gegenüberliegender Stirnflächen 1 mm große Löcher gebohrt und ein Silberdraht von 0,5 mm Durchmesser vollständig durchgezogen, so daß er aus den Stirnflächen jeweils 10 mm herausragte. Eine Mischung der Oxide von Bismut, Strontium, Calcium und Kupfer wurde auf 1050 °C geheizt, bis eine homogene Schmelze entstand. Die Schmelze wurde in die so vorbereitete Kupferform gegossen und erstarrte dort langsam. Das Material ist in diesem Zustand nicht supraleitend. Der von der erstarrten Schmelze umschlossene Silberdraht hatte bei Raumtemperatur einen Widerstand von 9,7 . 10⁻³ Ω.

### Beispiel 1b: (Vergleichsbeispiel)

Abweichend von Beispiel 1a wurden die Drähte nicht durch die Mitte der Stirnflächen, sondern am Boden der Kupferform entlanggeführt, so daß der Draht nur teilweise von der Schmelze umschlossen war bzw. direkt oberhalb der Oberfläche der erstarrten Schmelze lag. Der Widerstand dieses Drahtes betrug bei Raumtemperatur 0,7 . 10⁻³ Ω und entsprach damit dem Widerstand, der für diesen Draht vor der Umhüllung mit Schmelze ermittelt wurde.

Offensichtlich wurde im Beispiel 1a der Silberdraht, der mittig durch die langsam erstarrende Schmelze verlief, durch die hohe Anfangstemperatur der Schmelze (1050 °C) teilweise angeschmolzen bzw. aufgelöst, da der Schmelzpunkt für Silber 950 °C beträgt. Im Gegensatz dazu erfolgte die Abkühlung der Schmelze in der Nähe der Kupferformwand sehr rasch. Durch eine Anordnung des Drahtes in dieser Randzone des Massivkörpers (wie in Beispiel 1a) kann die Verminderung des Silberdrahtquerschnitts unter dem Einfluß der Schmelze verhindert werden.

### Beispiel 1c:

Das Beispiel 1a wurde mit einem 0,5 mm dicken Golddraht anstelle des Silberdrahtes wiederholt. Der Widerstand des Drahtes in der erstarrten Schmelze betrug 0,95 . 10⁻³ Ω und entsprach damit genau dem Widerstand, der für einen gleichartigen Draht, außerhalb der erstarrten Schmelze, ermittelt wurde. Das abweichende Verhalten des Golddrahtes ist auf den höheren Schmelzpunkt des Goldes (1065 °C) zurückzuführen.

### Beispiel 2:

Aus einem 0,5 mm dicken Silberblech wurden zwei Ringe von je 10 mm Breite und 8 mm Durchmesser geformt und über zwei Silberdrähte (Durchmesser 0,5 mm, Länge 100 mm) miteinander durch Punktschweißen verbunden (Fig. 2).

Diese Konstruktion wurde in ein einseitig geschlossenes Quarzglasrohr von 8 mm lichtem Durchmesser und 120 mm Länge als Matrize hineingeschoben. Eine Mischung der Oxide von Bismut, Strontium, Calcium und Kupfer im Verhältnis der Metalle von 2 : 2 : 1 : 2 wurde auf 1000 °C geheizt, bis eine homogene Schmelze entstand. Diese Schmelze wurde in das so vorbereitete Quarzrohr gegossen, wobei die Silberdrähte teilweise von der Schmelze umschlossen wurden. Nach Abkühlung auf Raumtemperatur wurde der Formkörper dem Quarzrohr entnommen.

Der Gesamtwiderstand der in der erstarrten Schmelze befindlichen Drähte wurde zu 1,2 . 10⁻³ Ω ermittelt und entsprach damit dem Widerstand vor der Umhüllung mit geschmolzenen Metalloxiden.

### Beispiel 3:

Der nach Beispiel 2 hergestellte Formkörper wurde in einem Röhrenofen unter einem Gemisch von Luft und Stickstoff im Verhältnis 1 : 1 mit einer Aufheizgeschwindigkeit von 300 °C/h auf 750 °C aufgeheizt, und 24 Stunden bei dieser Temperatur getempert. Anschließend wurde unter Luftatmosphäre auf 830 °C aufgeheizt und weitere 36 Stunden bei 830 °C getempert.

Das Material wurde supraleitend bei 89 K (R = 0 Ω ). Der Übergangswiderstand zwischen Silber und Supraleiter wurde zu 0,028 . 10⁻³ Ω ermittelt.

### Beispiel 4a:

Der nach Beispiel 3 hergestellte Formkörper wurde mit einer Gleichstromquelle verbunden und (ohne äußeres Magnetfeld) bei der Temperatur des flüssigen Stickstoffs (77 K) ein Gleichstrom von 20 A durch den Formkörper geleitet. Nach dem Herausziehen des Formkörpers aus dem Stickstoffbad erfolgte ein sprunghafter Anstieg des Widerstandes im Formkörper auf 0,210 . 10⁻³ Ω. Danach erfolgte ein langsamer, kontinuierlicher Anstieg des Widerstandes. Nach 25 Sekunden war der Draht durchgeschmolzen und der Widerstand erhöhte sich wieder sprunghaft auf 50 . 10⁻³ Ω.

Der metallische Leiter übernahm also nach dem Herausziehen aus dem Stickstoffbad für 25 Sekunden den größten Teil des Stromflusses.

### Beispiel 4b: (Vergleichsbeispiel)

Die Beispielfolge 2, 3, und 4a wurde wiederholt mit der Änderung, daß die Silberblechringe nicht durch Silberdrähte miteinander verbunden waren. Nach dem Herausziehen des Formkörpers aus dem Stickstoffbad stieg der Widerstand sprunghaft auf 55 . 10⁻³ Ω.

### Beispiel 5:

In den Boden eines einseitig geschlossenen Quarzrohres von 120 mm Länge wurde eine Öffnung von 1 mm Durchmesser gebohrt. Durch dieses Quarzrohr wurde ein 0,5 mm dicker Golddraht geführt und jeweils oberhalb und unterhalb des Quarzrohres fest verspannt, so daß der Golddraht in der Mitte des Rohres angeordnet war. In das so vorbereitete Rohr wurde eine Oxidschmelze, wie in Beispiel 2 angegeben, gegossen.

Die Temperung des erhaltenen Formkörpers erfolgte wie im Beispiel 3 beschrieben. Anschließend wurden an den Enden des Formkörpers Goldkontakte aufgesputtert, die bei 550 °C 0,5 Stunden wärmebehandelt wurden. Durch diesen Formkörper wurde bei der Temperatur des flüssigen Stickstoffs ein Strom von 20 A geleitet. Nach dem Herausziehen der Probe aus dem Stickstoffbad erfolgte ein sprunghafter Anstieg des Widerstandes im Formkörper auf 0,405 . 10⁻³ Ω. Danach erfolgte ein langsamer, kontinuierlicher Anstieg des Widerstandes. Nach 35 Sekunden war der Draht durchgeschmolzen und der Widerstand erhöhte sich sprunghaft auf 65 . 10⁻³ Ω. Wieder übernahm der metallische Leiter nach dem Wegfall der Stickstoffkühlung für eine begrenzte Zeit den größten Teil des ursprünglich nur im Supraleiter geflossenen Stromes.

### Beispiel 6:

Durch Punktschweißen wurden zwei aus 0,5 mm dickem Silberblech gefertigte Ringe (Außendurchmesser 47 mm, Innendurchmesser 37 mm) mit zehn Silberdrähten (Durchmesser 0,5 mm, Länge 200 mm) so verbunden, daß die Silberdrähte an der Innenseite der Ringe angeschweißt waren und mit den Blechen einen Käfig bildeten.

Dieser Käfig wurde in eine waagrecht liegende, zylinderförmige Kokille aus dünnem Edelstahlblech (Durchmesser 50 mm, Länge 200 mm) geschoben. Die Kokille wurde mit 500 Upm um ihre Längsachse gedreht und über eine Rinne eine Schmelze (Schmelztemperatur: 1000 °C) der Oxide von Bismut, Strontium, Calcium und Kupfer im Verhältnis der Metalle von 2 : 2 : 1 : 2 eingefüllt. Aufgrund der Zentrifugalkraft verteilte sich die Schmelze schnell und gleichmäßig an der Kokillenwand zu einem Hohlzylinder. Nach Abkühlung konnte der Kokille ein Hohlzylinder mit 4 mm Wandstärke entnommen werden. Die Silberdrähte befanden sich dabei in der Außenwand des Hohlzylinders und waren teilweise von der erstarrten Schmelze umhüllt (Fig. 3).

Durch die Umhüllung mit der Schmelze wurde der ursprüngliche Widerstand der Silberleiter nicht verändert.

## Patentansprüche

1. Stabilisierter, keramischer Hochtemperatur-Supraleiter auf der Basis geschmolzener Metalloxide des Bismuts, Strontiums, Calciums und Kupfers, wobei ein metallischer Leiter parallel zum Hochtemperatur-Supraleiter geführt ist und der Hochtemperatur-Supraleiter mit dem metallischen Leiter in Kontakt steht, dadurch gekennzeichnet, daß der Hochtemperatur-Supraleiter und der metallische Leiter gemeinsame Kontaktstücke aufweisen, an welchen der Stromanschluß erfolgt.

2. Hochtemperatur-Supraleiter nach Anspruch 1, dadurch gekennzeichnet, daß ein oder mehrere metallische Leiter die Kontaktstücke für die Stromanschlüsse verbinden.

3. Hochtemperatur-Supraleiter nach Anspruch 1 oder 2, dadurch gekennzeichnet, daß der metallische Leiter aus Edelmetall besteht.

4. Hochtemperatur-Supraleiter nach Anspruch 3, dadurch gekennzeichnet, daß man als Edelmetall Ag, Au, Ru, Os, Rh, Ir, Pd oder Pt oder eine diese Edelmetalle enthaltende Legierung verwendet.

5. Hochtemperatur-Supraleiter nach einem der Ansprüche 1 bis 4, dadurch gekennzeichnet, daß der metallische Leiter von dem Hochtemepratur-Supraleiter vollständig oder teilweise umhüllt ist.

6. Hochtemperatur-Supraleiter nach einem der Ansprüche 1 bis 5, dadurch gekennzeichnet, daß der Hochtemperatur-Supraleiter aus den geschmolzenen Metalloxiden in Form eines Rohres im Schleudergußverfahren hergestellt wird.

7. Hochtemperatur-Supraleiter nach einem der Ansprüche 1 bis 6, dadurch gekennzeichnet, daß im Schleudergußverfahren die Rohrenden mit ringförmigen Kontaktstücken für den Stromanschluß ausgerüstet werden, wobei die beiden Kontaktstücke durch einen oder mehrere metallische Leiter verbunden sind.

8. Verfahren zur Herstellung stabilisierter, kermaischer Hochtemperatur-Supraleiter nach einem der Ansprüche 1 bis 7, dadurch gekennzeichnet, daß man in einer Matrize einen oder mehrere metallische Leiter parallel zur Matrizen-Längsachse anordnet und die Matrize mit den aufgeschmolzenen Metalloxiden von Bismut, Strontium, Calcium und Kupfer im Molverhältnis der Metalle von 2 : 2 : 1 : 2 auffüllt und erstarren läßt.

9. Verfahren nach Anspruch 8, dadurch gekennzeichnet, daß man die erstarrte Schmelze in einer ersten Stufe bei Temperaturen von 710 bis 810 °C und einer zweiten Stufe in sauerstoffhaltiger Atmosphäre bei Temperaturen von 750 bis 870 °C tempert.

10. Verfahren zur Herstellung stabilisierter, keramischer Supraleiter nach einem der Ansprüche 1 bis 5, dadurch gekennzeichnet, daß man in einer Matrize einen oder mehrere metallische Leiter parallel zur Matrizen-Längsachse anordnet und die Matrize mit pulverförmigen Metalloxiden oder fertigem Supraleiterpulver auffüllt und in die Matrize vollständig oder teilweise aufschmilzt, danach in einer ersten Stufe in Luftatmosphäre bei 710 bis 810 °C und einer zweiten Stufe in sauerstoffhaltiger Atmosphäre bei 750 bis 870 °C tempert.

11. Verfahren nach Anspruch 10, dadurch gekennzeichnet, daß man als Matrizenmaterial Silber oder Gold einsetzt.

12. Verfahren nach Anspruch 9 oder 10, dadurch gekennzeichnet, daß man in der ersten Stufe 0,5 bis 60 Stunden tempert.

13. Verfahren nach Anspruch 9 oder 10, dadurch gekennzeichnet, daß man in der zweiten Stufe 6 bis 100 Stunden tempert.

## Claims

1. A stabilized, ceramic high-temperature superconductor based on molten metal oxides of bismuth, strontium, calcium and copper, a metallic conductor being taken parallel to the high-temperature superconductor and the high-temperature superconductor being in contact with the metallic conductor, wherein the high-temperature superconductor and the metallic conductor have common contact pieces where the current connection is made.

2. The high-temperature superconductor as claimed in claim 1, wherein one or more metallic conductors connect the contact pieces for the current connections.

3. The high-temperature superconductor as claimed in claim 1 or 2, wherein the metallic conductor is composed of a rare metal.

4. The high-temperature superconductor as claimed in claim 3, wherein the rare metal used is Ag, Au, Ru, Os, Rh, Ir, Pd or Pt or an alloy containing these rare metals.

5. The high-temperature superconductor as claimed in any one of claims 1 to 4, wherein the metallic conductor is wholly or partially surrounded by the high-temperature superconductor.

6. The high-temperature superconductor as claimed in any one of claims 1 to 5, wherein the high-temperature superconductor is made in the form of a tube from the molten metal oxides by the spin-casting process.

7. The high-temperature superconductor as claimed in any one of claims 1 to 6, wherein, in the spin-casting process, the tube ends are fitted with annular contact pieces for the current connection, the two contact pieces being connected by means of one or more metallic conductors.

8. A process for producing a stabilized, ceramic high-temperature superconductor as claimed in any one of claims 1 to 7, which comprises arranging one or more metallic conductors in a die parallel to the longitudinal axis of the die and filling the die with the molten metal oxides of bismuth, strontium, calcium and copper in a molar ratio of the metals of 2 : 2 : 1 : 2 and allowing the melt to solidify.

9. The process as claimed in claim 8, wherein the solidified melt is heat-treated in a first stage at temperatures of 710 to 810°C and in a second stage, in an oxygen-containing atmosphere, at temperatures of 750 to 870°C.

10. A process for producing a stabilized, ceramic superconductor as claimed in any one of claims 1 to 5, wherein one or more metallic conductors are arranged in a die parallel to the longitudinal axis of the die and the die is filled with pulverulent metal oxides or finished superconductor powder and the powder in the die is wholly or partially melted and then heat-treated in a first stage at 710 to 810°C in an air atmosphere and in a second stage at 750 to 870°C in an oxygen-containing atmosphere.

11. The process as claimed in claim 10, wherein the die material used is silver or gold.

12. The process as claimed in claim 9 or 10, wherein the heat treatment in the first stage is carried out for 0.5 to 60 hours.

13. The process as claimed in claim 9 or 10, wherein the heat treatment in the second stage is carried out for 6 to 100 hours.

## Revendications

1. Supraconducteur à température élevée, céramique, stabilisé, à base d'oxydes métalliques fondus du bismuth, du strontium, du calcium et du cuivre, un conducteur métallique étant introduit parallèlement au supraconducteur à température élevée et le supraconducteur à température élevée étant en contact avec le conducteur métallique, caractérisé en ce que le supraconducteur à température élevée et le conducteur métallique présentent des plots de contact communs sur lesquels se fait le raccordement de courant.

2. Supraconducteur à température élevée selon la revendication 1, caractérisé en ce qu'un ou plusieurs conducteurs métalliques relient les plots de contact pour les raccordements de courant.

3. Supraconducteur à température élevée selon la revendication 1 ou 2, caractérisé en ce que le conducteur métallique est constitué de métal précieux.

4. Supraconducteur à température élevée selon la revendication 3, caractérisé en ce qu'on utilise comme métal précieux Ag, Au, Ru, Os, Rh, Ir, Pd ou Pt ou un alliage contenant ces métaux précieux.

5. Supraconducteur à température élevée selon l'une quelconque des revendications 1 à 4, caractérisé en ce que le conducteur métallique est totalement ou partiellement enveloppé du supraconducteur à température élevée.

6. Supraconducteur à température élevée selon l'une quelconque des revendications 1 à 5, caractérisé en ce que le supraconducteur à température élevée est préparé à partir des oxydes métalliques fondus dans la forme d'un tube dans un procédé de coulée centrifuge.

7. Supraconducteur à température élevée selon l'une quelconque des revendications 1 à 6, caractérisé en ce que les extrémités de tube sont munies dans le procédé de coulée centrifuge de plots de contact annulaires pour le raccordement de courant, les deux plots de contact étant reliés par l'intermédiaire d'un ou plusieurs conducteurs métalliques.

8. Procédé pour la préparation de supraconducteurs à température élevée, céramiques, stabilisés selon l'une quelconque des revendications 1 à 7, caractérisé en ce que l'on dispose dans une matrice un ou plusieurs conducteurs métalliques parallèlement à l'axe longitudinal de la matrice et on remplit la matrice avec les oxydes métalliques fondus du bismuth, du strontium, du calcium et du cuivre dans un rapport molaire des métaux de 2 : 2 : 1 : 2 et on laisse solidifier.

9. Procédé selon la revendication 8, caractérisé en ce qu'on tempère la masse fondue solidifiée dans une première étape à des températures de 710 à 810°C et dans une deuxième étape dans une atmosphère oxygénée à des températures de 750 à 870°C.

10. Procédé pour la préparation de supraconducteurs céramiques stabilisés selon l'une quelconque des revendications 1 à 5, caractérisé en ce que l'on dispose dans une matrice un ou plusieurs conducteurs métalliques parallèlement à l'axe longitudinal de la matrice et on remplit la matrice avec des oxydes métalliques pulvérulents ou de la poudre préfabriquée de supraconducteur et on fait fondre partiellement ou totalement dans la matrice, après quoi on tempère dans une première étape dans une atmosphère d'air à une température de 710 à 810°C et dans une deuxième étape dans une atmosphère oxygénée à une température de 750 à 870°C.

11. Procédé selon la revendication 10, caractérisé en ce que l'on utilise comme matériau de matrice de l'argent ou de l'or.

12. Procédé selon la revendication 9 ou 10, caractérisé en ce que l'on tempère dans la première étape pendant 0,5 à 60 h.

13. Procédé selon la revendication 9 ou 10, caractérisé en ce qu'on tempère dans la deuxième étape pendant 6 à 100 h.
